# EUROPEAN PATENT APPLICATION

(11) **EP 4 585 713 A2**
(43) Date of publication of application: **16.07.2025**
(21) Application number: 24216390.5
(22) Date of filing: 29.11.2024
(51) Int. Cl.: C23C 14/06, C23C 14/58

(54) **APPARATUSES AND METHODS FOR PRECONDITIONING ADVANCED MATERIALS**

(30) Priority: 19.12.2023 US 202363612245 P; 25.10.2024 US 202418926984
(71) Applicant: Technetics Group LLC, Charlotte, NC 28209 (US)
(72) Inventor: JAEGER, William, 28209 Charlotte (US); HALL, Cory, 28209 Charlotte (US)
(74) Representative: J A Kemp LLP

(57) **Abstract**

An apparatus, system, and method to modify the surface of a workpiece having an advanced material coating is provided. The advanced material coating is a diamond-like coating such as, for example, an amorphous carbon coating material. The technology provided includes a surface modification assembly that provides a photonic radiation source, such as a laser, that is tuned to the advance material such that the energy from the laser is absorbed by the surface to modify the bonds in the coating allowing a defined portion of the coating to be photodegraded and removed.

## Description

### CROSS-REFERENCE TO RELATED PATENT APPLICATIONS

The present application claims priority to U.S. Provisional Patent Application No. 63/612,245, filed December 19, 2023, the disclosure of which is incorporated herein by reference as if set out in full.

### BACKGROUND

The technology of the present application relates to modifying and shaping advanced materials and, more particularly, to modifying a defined portion, or surface area, of the advanced materials to shape the advanced material prior to installation to or use in manufacturing process chambers.

Conventionally, materials, such as, ceramics and the like, are used in manufacturing process chambers ("MPC") in part for their high wear resistance. Even though the materials are resistant to the environment in the MPC they are in some instances coated with other materials, such as, for example, advanced materials. The workpiece, as well as any coating, has beneficial properties relating to wear resistance, strength, and the like to name but two (2) specific properties. The workpiece (be it ceramic or otherwise) often is coated with an advanced material that also is hard, strong, and wear resistant to the environment. Sometimes, the workpiece and/or coating is required to be processed or shaped. The hard, wear resistant materials, such as the aforementioned advanced materials, are difficult to modify to the required shapes that deliver the best performance for the processes in which they are used. Moreover, the advanced materials, and/or other MPC pieces may require use of the MPC outside of its intended purpose to produce product. Using the MPC in this manner may result in the MPC not being used for its intended purpose and results in down time of the device, with the associated high costs of not being used for its intended purpose.

One characteristic of materials that are useful in MPC environments is the wear resistance of the materials, which is often due to, in part, its hardness and strength. The hardness and wear resistance, which makes the material useful in the MPC environments, makes the material difficult to work, shape, and/or otherwise manipulate. Additionally, these materials often are coated another material such as advanced materials,

Advanced materials and wear resistant workpieces are difficult to shape or otherwise manipulate. Often the workpieces need to be worked prior to use for a variety of reasons including, for example, a workpiece coated with an advanced material may require a contact area (or minimum contact area "MCA") on the advanced material to allow for the creation of a gap between a wafer that is to be carried by workpiece. Significant processing of the workpiece with the advanced material coating is currently required to achieve the required shapes and clearances with the precision dimensional results required for optimal performance and function. The processing is time consuming, burdensome, and otherwise inefficient.

As can be appreciated, the need to use the chambers to burn in the materials and the inconvenience of the processing is time consuming and costly. Thus, against this background, it is desirable to provide apparatuses and method for preconditioning advanced materials.

### SUMMARY

This Summary is provided to introduce a selection of concepts in a simplified form that are further described below in the Detailed Description. This Summary, and the foregoing Background, is not intended to identify key aspects or essential aspects of the claimed subject matter. Moreover, this Summary is not intended for use as an aid in determining the scope of the claimed subject matter.

In some aspects of the technology, apparatuses and methods to modify defined portions of a surface of a substrate are provided, which substrate may be a workpiece or a workpiece coated with one or more advanced materials. The apparatuses and methods include directing a surface modification assembly to apply a process to a defined portion of the surface of the substrate. In at least one embodiment, the surface modification assembly is a laser that directs a laser beam at the surface where the photons from the laser are absorbed by the substrate. The absorption of the photons causes a photolytic degradation of the structure such that the defined portion is ablated or modified such that it can be mechanically removed.

In some embodiments, the method comprises directing a laser to one or more defined portions of the surface of a workpiece. In certain aspects, the surface of the workpiece may be coated with an advanced material. In certain embodiments, the advanced material coating may be a diamond-like-coating.

These and other aspects of the present system and method will be apparent after consideration of the Detailed Description and Figures herein.

### BRIEF DESCRIPTION OF THE DRAWINGS

Non-limiting and non-exhaustive embodiments of the present invention, including the preferred embodiment, are described with reference to the following figures, wherein like reference numerals refer to like parts throughout the various views unless otherwise specified.
Figure 1 is a system for preconditioning a material consistent with the technology of the present application.
Figure 2 is an example of varying levels of coating removal illustrating control in depth consistent with the technology of the present application.
Figure 3 is an example of processed material consistent with the technology of the present application vs unprocessed material.
Figure 4 is an example of varying process outcomes as it relates to cross sectional profile of removing a defined portion consistent with the technology of the present application.

### DETAILED DESCRIPTION

The technology of the present application will now be described more fully below with reference to the accompanying figures, which form a part hereof and show, by way of illustration, specific exemplary embodiments. These embodiments are disclosed in sufficient detail to enable those skilled in the art to practice the technology of the present application. However, embodiments may be implemented in many different forms and should not be construed as being limited to the embodiments set forth herein. The following detailed description is, therefore, not to be taken in a limiting sense.

The technology of the present application is described with specific reference to certain exemplary embodiments such as using lasers, which may include infrared, visible light, and/or, ultraviolet lasers, to process defined portions of a material's surface, such as the surface of a workpiece, an advanced material, which may be a diamond-like-coating, or the like. However, the technology described herein may be used with applications other than those specifically described herein. For example, the technology of the present application may be applicable to using other photonic radiation sources, chemical preconditioning, manual preconditioning, masking technology along with mechanical ablations, vapor deposition technologies, combinations that may or may not include lasing, or the like. Also, in certain embodiments, the technology may be used to modify materials other than advanced materials. For example, the technology of the present application may modify advanced materials that include diamond-like-coatings as well as ceramics, ceramic-like surfaces, and the like. Moreover, the technology of the present application will be described with relation to exemplary embodiments. The word "exemplary" is used herein to mean "serving as an example, instance, or illustration." Any embodiment described herein as "exemplary" is not necessarily to be construed as preferred or advantageous over other embodiments. Additionally, unless specifically identified otherwise, all embodiments described herein should be considered exemplary.

In certain embodiments of the technology presented in this application, a substrate for use in a manufacturing processing chamber ("MPC") is provided. The substrate, or workpiece, may have a surface, which may be coated with a material. The substrate surface, or the material coating on the substrate, is often a strong, hard, wear resistant material. The substrate or workpiece also may be coated with a material such as, for example, one or more advanced materials. Advanced materials include diamond-like-carbon coatings (DLC). Generally, a DLC comprises an amorphous carbon material. DLCs are chemically inert and wear resistant making them good materials form MPC, but also make it difficult to work the surface of the DLC once formed. The surface of the substates and or coatings, such as the aforementioned DLC, in some instances need to be modified for application in MPCs. For example, as mentioned above, the workpiece in an MPC may require an advanced material coating like a DLC to provide for a gap between a carried wafer and the workpiece. The DLC is shaped subsequent to formation to accommodate this by the technology of the present application. In particular, the technology of the present application modifies the surface of the coating (or workpiece surface) by ablating a defined portion of the surface, modifying the defined portion of the surface, or the like to remove the defined portion (or portions) such that the shape of the surface of the coating, and/or the surface of the workpiece, may be altered as required but the material characteristics of the remaining coating, and/or workpiece is the same as prior to the application of the technology outlined herein. In some applications, the modification of the structure by the processes described herein may reduce the hardness in the defined portions of the surface to allow the surface to be more easily manipulated to remove the material, which manipulation includes shaping the surface in a direction into the material. As used herein, the term defined portion or defined portion of the surface means a volume having a surface area generally parallel to the surface of the substrate and a depth into the substrate generally perpendicular to the surface. In other words, the defined portion comprises dimensions in the X, Y, and Z directions. Ideally, the defined, portion of the surface can be modified without the modification process affecting any of the surface outside of the defined, portion of the surface. The defined, portion of the surface is generally of a defined geometry, such as a circle, parallelogram, other shape, or even random shapes in some instances. The defined portion on the surface of the substrate (or the coating thereon) has a specific footprint surface area on the surface that can be shaped by the technology of the present application. The surface of the workpiece typically is hard and wear resistant, such as the DLC defined above. The properties can make adjustments to the surface difficult without treating the surface. The technology of the present application is a modification process of defined portions of the surface of the substrate, which allows removal of the defined portions of the surface of the workpiece and allows shaping the workpiece. For purposes of the present application the term surface should be understood to include a depth into the substrate.

The defined portion, for purposes of the present application comprises a volume, such as for example, a cylindrical shape having a radius and a depth. Other volumes are possible, such as parallelograms having a defined portion in the X and Y direction (parallel to the surface of the substrate), but also in the Z direction (perpendicular to the surface of the substrate). In some aspects, the depth is a curvature that forms a scoop like structure.

In at least one exemplary embodiment, the treatment of the substrate modifies one or more defined portions of the surface of the substrate. Modified as used herein should be construed to include remove, such as by ablation or vaporization, alter the structure, such as by causing voids or the like to form in the structure of the modified surface, break bonds in the composition of the structure, combinations thereof, or the like. For example, a substrate having a DLC is modified by the technology described herein to shape the surface of the DLC by removing the one or more defined portion, which defined portion has vectors in each of the X, Y, and Z direction. The modification to the surface of the substrate may remove the material (such via ablation or vaporization) or allows for the defined portion to be further manually manipulated, such as, removed via mechanical polishing, chemical processing, or the like without significant degradation of the remainder of the DLC in areas outside the defined portion's total volume. In other words, the shaping of the DLC in this exemplary embodiment includes forming one or more depressions, recesses, grooves, detents, or the like in the surface. Moreover, the bottom layer and sidewalls of the defined portion maintains the structural of the original material, such as, for example, the hardness of the DLC.

In certain aspects, the surface of the substrate, be it a DLC, another advanced material, or something else, in one or more defined portions may be modified by directing a laser at the surface and constraining the laser from impacting areas of the surface outside of the defined portions. The laser would be tightly focused on just the area being modified. The modification process includes using a laser to transfer energy from the laser to the surface of the substrate in the defined portions. The energy of the laser, in certain aspects, is absorbed by the surface material, which causes a modification of the structure of surface of the substrate, which is generally known as photolytic degradation processing or photonic bombardment. Without being constrained by a theory, the photolytic degradation, it is believed, breaks bonds between the molecules forming the substrate. The laser described herein is but one means for modifying the surface of the substrate or the DLC. In certain aspects, the modification includes ablating or vaporizing the surface material in the defined portion. In other aspects, the modification includes forming voids in, or foaming, the material in the defined portion to allow removal by a mechanical means, such as, for example, grinding, polishing, blasting, or the like. Although the process to modify the surface consistent with the technology described herein causes a change in the structure of the material in the defined portion, which in some cases lowers the hardness or the material in the defined portion where the photons bombard the surface and in some cases simply vaporizes the material, the process uses a focused or targeted laser beam that should limit the impact of the energy transfer outside of the defined portion. Also, the photonic bombardment modifies the surface via absorption of the energy, but the thermal impact on the surface of the substrate is low such that the processing of the surface of the substrate should result in no heat increase or limited heat increase of the substrate to diminish thermal stresses. To limit the heat transfer from the energy absorption, the radiation source used in the process may need to be tuned to the particular material being modified. For example, using a laser to modify the structure of the DLC coating on the surface of a substrate may use an ultraviolet light laser with a wavelength of between about 100 and 400 nm and a power of just above 0 Watts to about 20 Watts. Generally, this results in absorption of the energy and a modification of the structure of the DLC in a defined, portion of the surface in an X, Y, and Z direction (a specific volume of material). In some embodiments, the absorption results in vaporization or ablation of the material. In other embodiments, the absorption forms voids in the material, which may result in the material become a gel like consistency or foam like consistency.

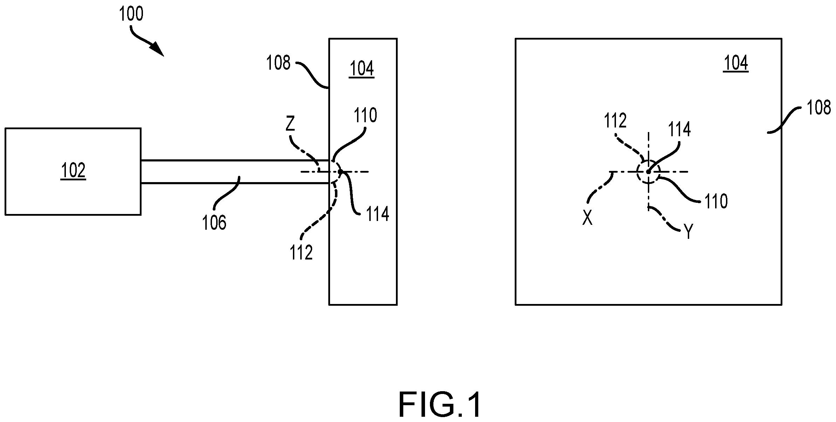

With reference now to figure 1, a system 100 that allows a workpiece to have defined portions of its surface modified is provided. The system 100 includes a surface modification assembly 102 and a workpiece 104. The surface modification assembly 102, or means for modifying the surface of the workpiece, may comprise a laser, other photonic radiation sources, chemical preconditioning, manual preconditioning, masking technology along with mechanical ablations, vapor deposition technologies, or combinations that may or may not include lasing. The surface modification assembly 102, in this exemplary embodiment, comprises a laser 102. The laser 102 produces a beam 106 that is directed to a defined portion 110 of the surface 108 of the workpiece 104. The laser 102, in this exemplary embodiment, ablates the defined portion 110, which defined portion comprises a surface area and a depth. While it is believed to be dependent on settings of the radiation source, such as, for example, the wavelength, focal length, and power of the laser, the depth is controllable of the penetration is controllable to about .01 microns. The defined portion 110, after modification consistent with the technology herein, has at least one sidewall layer 112 and a bottom layer 114. The sidewall layer 112 and the bottom layer 114 should maintain the same, or approximately the same, material characteristics of the original material, at least with respect to wear resistance, strength, and the like.

The laser 102, in this exemplary embodiment, is generally tuned to the material being ablated or modified. For example, for a DLC, the laser may be a UV laser as outlined above. While shown as a single laser and a single defined portion, multiple lasers may be used to modify or precondition multiple defined portions. Also, a single laser may be directed to multiple defined portions on the surface of a substrate.

The surface modification assembly 102 may be, in certain embodiments, another mechanism to modify the defined, portion 110 of the surface of the substrate 108. In some aspects, the photonic radiation source may be light emitting diode, superluminescent diodes, or the like rather than a laser. In other aspects, rather than photonic bombardment, other surface modification devices may be used. For example, the surface modification assembly 102 may be a chemical bath where the substrate in coated with a chemical resistant material in all but the defined portion 110. The substrate 108 with the chemical resistant material is inserted into the bath such that the chemical in the bath modifies the defined portion 110. After the substrate is modified by the chemical bath, the chemical resistant material may be removed.

With reference back to figure 1, by using a directed and focused laser 102 where the radiation source, e.g., the laser, has parameters tuned to the particular material, the system 100 allows for the surface modification and shaping (or attends to the modification and shaping by vaporization or the like). The energy of the laser ablates the defined portion 110 by vaporizing the hard structure, such as the DLC. In some exemplary embodiments, the system 100 causes modification to the structure by inducing voids into the composition such that the material turns into a less hard structure such that the material in the defined portion 110 may be removed to form a recess. In the exemplary embodiment of the DLC using the laser as identified above, the defined portion may turn into a foam like consistency that is removable by a mechanical means, such as, for example, polishing, grinding, or the like. Other surface modification assemblies 102 may result in a different removal process, such as, for example, the chemical process may modify and remove material substantially simultaneously. In other words, the process as defined herein allows the surface of the workpiece or the coating on the workpiece to be shaped.

The use of the laser 102 facilitates targeting the defined portion 110 that includes a surface area in the X, Y direction on the surface of the substrate 108 as well as a depth in the Z direction into the substrate 108, as shown in figure 1. In certain aspects, the modification process reduces the average surface roughness in the treated defined portions. In certain embodiments, the surface modification assembly 102, such as the laser 102, is directed to the defined portion 110. The modification process may be set for a pulse frequency between about 20kHz to about 600kHz, or more particularly to a range of between 40kHz and 400kHz, and a scan speed, such as a scan speed of between 1 to 12000 mm/sec as an example. This is, in part, to limit the penetration of the surface modification to a particular depth. Further depth may be achieved by multiple applications of the surface modification assembly 102 to the defined portion 110.

Based on the work piece composition, a radiation source (or chemical source) is tuned (by energy, wavelength, and intensity for a laser or a composition, pH, and strength for a chemical) for the material to be modified. The specific settings are defined to provide a high absorption rate, which possibly has the added benefit that defects or inconsistencies in the substrate (or workpiece) have less effect on the outcome of the application of the laser.

With specific reference to the laser 102, the high energy absorption minimizes soot, burrs, heat and other negative outcomes that are seen with traditional laser processing methods. Also, using the laser 102 allows for processing of sensitive surfaces such that the surface area outside of the defined portion 110 maintains the original substrate (or workpiece) with it original compositions and states, such that substrate 108 maintains its original purpose or function, such as, for example, corrosion resistance or the like.

By selecting a material specific radiation, the benefit of high absorption rates mean lower energy transmission. This significantly reduces the chance of that energy being transferred or transmitted to adjacent components or materials. In small / complex micro structures such as advanced packaging or in the manufacture of complex electrostatic chucks where multiple functional coating may be used in the manufacture of the work piece the process described herein provides novel methods for patterning and modifying these materials. Also, the high absorption rates reduces any induced heating by the application or the radiation source to bombard the surface.

Although different for different materials, the laser 102 having the wavelength, power, and intensity identified above provides a high-energy photon that impacts the defined portion 110 of the workpiece 108 (or substrate 108). The high energy photon causes a photolytic degradation of the structure within the defined portion 110. Because the laser 102 is directed only to the defined portion, the change does not ripple through substrate 108 either laterally or vertically.

In one exemplary implementation of the technology as described herein, a laser with a short wavelength, such as above visible light spectrum, with a high energy and intensity as described above was used as the surface modification assembly 102 to modify a substrate 108 comprising Aluminum Nitride (ALN) coated with a DLC coating that was 3 microns thick. The surface modification assembly 102 was applied to modify the defined portions 110 of the surface 108 of the DLC coating to achieve a desired volume of modified material at the defined portions on the surface. A mechanical means of removing the modified material, such as polishing, was used to remove the material such that the surface of the DLC coating was shaped as desired by removing the volume of material ablated by the laser without modifying other parts of the DLC coating.

As can be appreciated, using the technology described herein as a preconditioning or modification process to modify a surface allows control of the surface subjected to the modification process. The process may be used to modify multiple aspects of many materials, coatings, surfaces and more, including, but not limited to, shape, size, surface finish, depth/height, density, removal, preparedness for secondary processing and more. For example, using a laser to photonically bombard a surface modifies the structure such that the surface to a defined depth may be shaped.

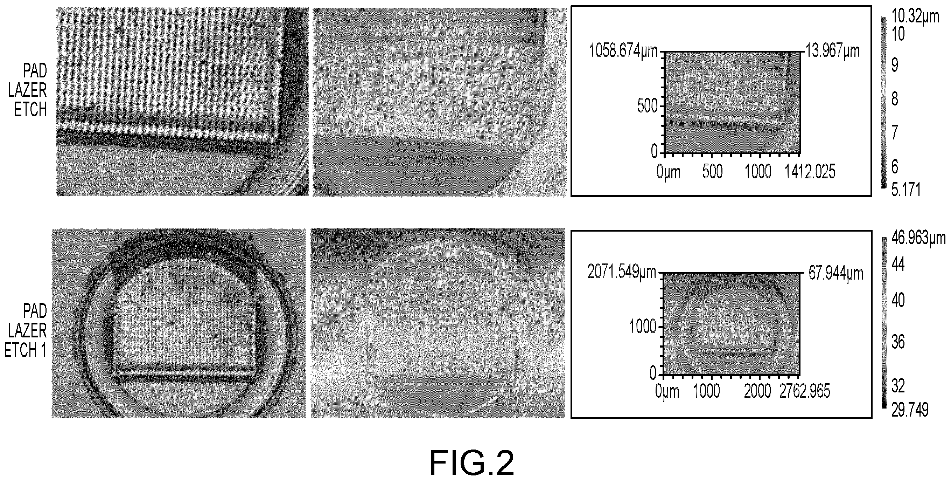

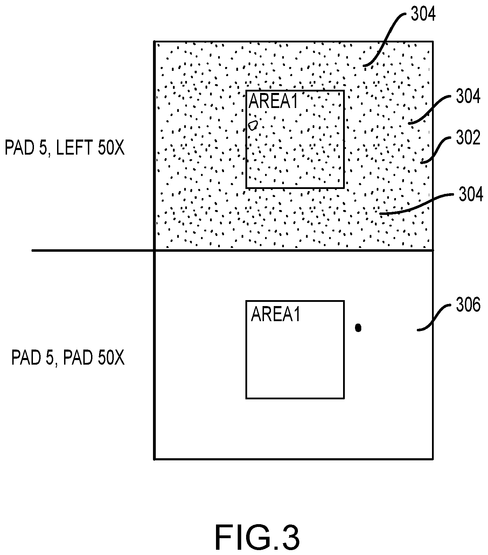

Figure 2 shows an ALN workpiece coated with a DLC. The surface of defined portions of the DLC was modified by a laser consistent with the technology as described herein. Figure 2 is an example of varying levels of coating removal illustrating control in depth consistent with the technology of the present application. Figure 3 similarly shows a plan view of a surface to which the laser preconditioning process was applied. The surface 302 was modified by a laser in defined portions 304, which appear as shallow depressions in the surface (the depressions almost appear as shadows). The surface 306 is the surface prior to modification by the laser of the present exemplary embodiment.

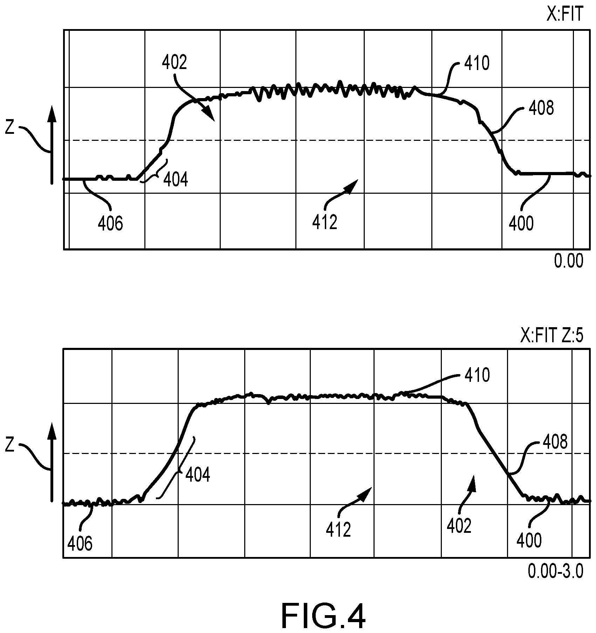

Figure 4 shows a profile of a cross section of a substrate 400 with an advanced material coating 402 with a modified portion 412. The surface 400 is shown with a single defined portion 402 having a height in the Z direction, which also is the depth of penetration into the surface. A portion of the advanced material 402 is modified, with a specific depth in the z direction to comprise the modification area 412. This area spans a defined width in the x and length in the y and can be controlled to any shape comprising of lines and curves in the x and y, with a depth in the z direction. The surface 406 of the material coating 402 generally remains unchanged and transitions due to application of the surface modification assembly 102 at transition point 404 to define modification area 412 sidewalls 408 and bottom 410

Although the technology has been described in language that is specific to certain structures and materials, it is to be understood that the invention defined in the appended claims is not necessarily limited to the specific structures and materials described. Rather, the specific aspects are described as forms of implementing the claimed invention. Because many embodiments of the invention can be practiced without departing from the spirit and scope of the invention, the invention resides in the claims hereinafter appended. Unless otherwise indicated, all numbers or expressions, such as those expressing dimensions, physical characteristics, etc. used in the specification (other than the claims) are understood as modified in all instances by the term "approximately." At the very least, and not as an attempt to limit the application of the doctrine of equivalents to the claims, each numerical parameter recited in the specification or claims which is modified by the term "approximately" should at least be construed in light of the number of recited significant digits and by applying ordinary rounding techniques. Moreover, all ranges disclosed herein are to be understood to encompass and provide support for claims that recite any and all subranges or any and all individual values subsumed therein. For example, a stated range of 1 to 10 should be considered to include and provide support for claims that recite any and all subranges or individual values that are between and/or inclusive of the minimum value of 1 and the maximum value of 10; that is, all subranges beginning with a minimum value of 1 or more and ending with a maximum value of 10 or less (e.g., 5.5 to 10, 2.34 to 3.56, and so forth) or any values from 1 to 10 (e.g., 3, 5.8, 9.9994, and so forth).

## Claims

1. A system to modify a surface of a workpiece, the system comprising:
a workpiece configured for use in a manufacturing processing chamber having a coating of an advanced material; and
a surface modification device comprising a photonic radiation source, wherein the photonic radiation source is selected from a group of photonic radiation sources consisting of: a laser, a plurality of lasers, a light emitting diode, a plurality of light emitting diodes, a superluminescent diode, plurality of superluminescent diodes, or a combination thereof;
wherein the surface modification device is configured to direct photonic radiation from the photonic radiation source to a defined portion of the surface of the workpiece, such that the defined portion of the workpiece is modified.

2. The system of claim 1 wherein the advanced material comprises a diamond-like coating on a workpiece;
wherein, optionally, the diamond-like coating comprises an amorphous carbon material.

3. The system of any one of claims 1 or 2 wherein the photonic radiation source comprises at least one laser tuned to photodegrade only the defined portion of the surface of the workpiece;
wherein, optionally, the at least one laser photodegrades a plurality of defined portions of the surface of the workpiece.

4. The system of claim 3 wherein the defined portion comprises at least one sidewall and at least a bottom.

5. The system of claim 4 wherein the at least one sidewall is perpendicular to a surface of the advanced material.

6. The system of claim 4 wherein the at least one sidewall is substantially perpendicular to the surface of the advanced material.

7. The system of any one of claims 3 to 6 wherein the defined portion comprises a surface area and a depth;
wherein, optionally, the photodegradation vaporizes the defined portion.

8. The system of claim 7 wherein the photodegradation causes voids to form in the defined portion and wherein the system comprises a machine to remove the advanced material from the voids by polishing.

9. A method of modify a surface of a workpiece, the method comprising:
providing a workpiece configured for use in a manufacturing processing chamber having a coating of an advanced material;
directing a beam from a photonic source at a plurality of defined portions of a surface of the advanced material wherein the beam is tuned to the advanced material such that there is a high absorption of the beam by the advanced material without excessive heat generation;
causing the beam to modify the surface of the advanced material by starting and stopping the beam such that the plurality of defined portions have a surface area and a depth, wherein the plurality of defined portions become a plurality of modified defined portions; and
removing the plurality of modified defined portions from the advanced material.

10. The method of claim 9 wherein, each of the plurality of defined portions are modified individually.

11. The method of claim 9 wherein, the plurality of defined portions are modified at least by two of the plurality of defined portions at a time.

12. The method of any one of claims 9 to 11 wherein, removing the plurality of modified defined portions is caused by vaporization of the plurality of modified defined portions by the beam;
wherein, optionally, removing the plurality of modified defined portions is caused by creating voids in the plurality of modified defined portions and mechanically removing the plurality of modified defined portions.

13. The method of any one of claims 9 to 12 wherein the photonic source is a laser; wherein, optionally, the laser is an ultraviolet laser.

14. The method of any one of claims 9 to 13 wherein the advanced material comprises an amorphous carbon material.

15. A photodegradation apparatus to modify the surface of a workpiece having an amorphous carbon material coating comprising:
a laser tuned such that the laser is configured to direct a beam having a surface area to a surface of the amorphous carbon material for a period of time such that energy from the beam is absorbed by the amorphous carbon material without generating significant heat, wherein the laser is tuned to break bonds in the amorphous carbon material over the surface area to a depth in a defined portion such that the defined portion is removed from the amorphous carbon material.
